# EUROPÄISCHE PATENTSCHRIFT

(11) **EP 1 868 243 B1**
(45) Veröffentlichungstag und Bekanntmachung des Hinweises auf die Patenterteilung: **10.12.2008**
(21) Anmeldenummer: 07011532.4
(22) Anmeldetag: 13.06.2007
(51) Int. Cl.: H01L 25/07

(54) **Leistungshalbleitermodul mit gegeneinander elektrisch isolierten Anschlusselementen**
High-performance semi-conductor module with opposing electrically insulated terminals
Module semi-conducteur de puissance doté d'éléments de connexion isolés électriquement les uns des autres

(30) Priorität: 14.06.2006 DE 102006027481
(43) Veröffentlichungstag der Anmeldung: 19.12.2007
(73) Patentinhaber: Semikron Elektronik GmbH & Co. KG Patentabteilung, 90431 Nürnberg (DE)
(72) Erfinder: Lederer, Marco, 90453 Nürnberg (DE); Popp, Rainer, 91580 Petersaurach (DE)

(56) Entgegenhaltungen:
- EP-A2- 0 828 341
- US-A- 4 313 128

## Beschreibung

Die Erfindung beschreibt ein Leistungshalbleitermodul in Druckkontaktausführung zur Anordnung auf einem Kühlbauteil. Einen Ausgangspunkt der Erfindung bilden Leistungshalbleitermodule wie sie beispielhaft aus der DE 197 19 703 A1 bekannt sind.

Derartige Leistungshalbleitermodule bestehen nach dem Stand der Technik aus einem Gehäuse mit mindestens einem darin angeordneten elektrisch isolierenden Substrat vorzugsweise zur direkten Montage auf einem Kühlbauteil. Das Substrat seinerseits besteht aus einem Isolierstoffkörper mit einer Mehrzahl darauf befindlicher gegeneinander isolierter metallischer Verbindungsbahnen und hierauf befindlichen und mit diesen Verbindungsbahnen schaltungsgerecht verbundenen Leistungshalbleiterbauelementen. Weiterhin weisen die bekannten Leistungshalbleitermodule Anschlusselemente für externe Last- und Hilfsanschlüsse sowie im Inneren angeordnete Verbindungselemente auf. Diese Verbindungselemente für schaltungsgerechte Verbindungen im Inneren des Leistungshalbleitermoduls sind meist als Drahtbondverbindungen ausgebildet.

Ebenfalls bekannt sind Druck kontaktierte Leistungshalbleitermodule, wie sie aus der DE 42 37 632 A1, der DE 199 03 875 A1 oder der DE 101 27 947 C1 bekannt sind. Bei erstgenannter Druckschrift weist die Druckeinrichtung ein stabiles, vorzugsweise metallisches, Druckelement zum Druckaufbau, ein elastisches Kissenelement zur Druck Speicherung und ein Brückenelement zur Druckeinleitung auf gesonderte Bereiche der Substratoberfläche auf. Das Brückenelement ist vorzugsweise ausgestaltet als ein Kunststoffformkörper mit einer dem Kissenelement zugewandten Fläche, von der eine Vielzahl von Druckfingern in Richtung der Substratoberfläche ausgehen.

Mittels einer derartigen Druckeinrichtung wird das Substrat auf ein Kühlbauteil gedrückt und somit der Wärmeübergang zwischen dem Substrat und dem Kühlbauteil dauerhaft sicher hergestellt. Das elastische Kissenelement dient hierbei der Aufrechterhaltung konstanter Druckverhältnisse bei unterschiedlichen thermischen Belastungen und über den gesamten Lebenszyklus des Leistungshalbleitermoduls.

Die DE 199 03 875 A1 bildet das bekannte Druckelement derart weiter, dass es einerseits ein besonders vorteilhaftes Verhältnis aus Gewicht und Stabilität aufweist und andererseits elektrisch isolierte Durchführungen aufweist. Hierzu ist das Druckelement als ein Kunststoffformkörper mit innen liegender Metallseele ausgebildet. Diese Metallseele weist Ausnehmungen für die Durchführung von Anschlusselementen, vorzugsweise Hilfsanschlusselementen in Federkontatkausführung, auf. Der Kunststoffformkörper umschließt diese Ausnehmungen derart, dass die Hilfsanschlusselemente mittels des Kunststoffformkörpers elektrisch von der Metallseele isoliert sind.

Es sind auch weitergebildete Druckelemente bekannt, die an ihrer dem Substrat zugewandten Oberfläche eine Vielzahl von Druckfingern aufweisen. Vorzugsweise weist hierbei die Metallseele noch eine voreingestellte Durchbiegung auf. In der Kombination beider Maßnahmen kann ein derartiges Druckelement die gesamte Funktionalität einer oben genannten Druckeinrichtung bereitstellen.

Aus der DE 101 57 947 C1 ist ein Leistungshalbleitermodul bekannt, wobei die Lastanschlusselemente derart ausgebildet sind, dass sie in Abschnitten eng benachbart senkrecht zur Substratoberfläche verlaufen und von dort ausgehende innere Kontakteinrichtungen, Kontaktfüße, aufweisen, die den elektrischen Kontakt zu den Leiterbahnen herstellen und gleichzeitig Druck auf das Substrat ausüben und somit dessen thermischen Kontakt zu einem Kühlbauteil herstellen. Der Druck wird hierbei mit Mitteln nach dem Stand der Technik eingeleitet.

Aus der EP 0 828 341 A2 ist ein Leistungshalbleitermodul bekannt, welches im Wesentlichen aus einer metallischen Grundplatte mit einer Mehrzahl hierauf angeordneten Substraten und darauf befindlich eine Mehrzahl von Leistungshalbleiterbauelementen aufweist. Diese Leistungshalbleiterbauelemente sind schaltungsgerecht mittels angeordneter Kontakteinrichtungen mit externen Last- und Steueranschlüssen verbunden, wobei die Kontakteinrichtungen für Emitter- und Kollektoranschlüsse jeweils nebeneinander und voneinander beabstandet auf einem Substrat angeordnet sind. Weiterhin werden die Kontakteinrichtungen mittels eines isolierenden Kunstharzrahmens gegeneinander vor Spannungsüberschlägen geschützt.

Der Erfindung liegt die Aufgabe zugrunde ein Leistungshalbleitermodul in Druckkontaktausführung vorzustellen, wobei die innere Isolation des Leistungshalbleitermoduls verbessert wird sowie die Ausbildung der Druckkontaktausführung vereinfacht wird.

Die Aufgabe wird erfindungsgemäß gelöst, durch die Maßnahmen der Merkmale des Anspruchs 1. Bevorzugte Ausführungsformen sind in den Unteransprüchen beschrieben.

Der erfinderische Gedanke geht aus von einer Anordnung eines Leistungshalbleitermoduls in Druckkontaktausführung auf einem Kühlbauteil mit mindestens einem Substrat, mindestens zwei hierauf angeordneten Leistungshalbleiterbauelementen, beispielhaft bipolaren Transistoren, einem Gehäuse und nach außen führenden Last- und Steueranschlusselementen. Das Substrat selbst weist einen Isolierstoffkörper auf und auf dessen erster, dem Inneren des Leistungshalbleitermoduls zugewandten Hauptfläche. Leiterbahnen mit Lastpotential. Weiterhin weist das Substrat vorzugsweise auch mindestens eine Leiterbahn mit Steuerpotential zu Ansteuerung der Leistungshalbleiterbauelemente auf.

Das Leistungshalbleitermodul weist weiterhin Lastanschlusselemente jeweils ausgebildet als Metallformkörper mit äußeren und inneren Kontakteinrichtungen und einem bandartigen Abschnitt auf. Die jeweiligen bandartigen Abschnitte der einzelnen Lastanschlusselemente sind vorzugsweise parallel zur Substratoberfläche und von dieser beabstandet angeordnet. Die inneren Kontakteinrichtungen, die von dem bandartigen Abschnitt ausgehen reichen zum Substrat und bilden dort schaltungsgerecht die Kontakte der Lastanschlüsse aus. Vorzugsweise kontaktieren sie hierzu auf dem Substrat die Leiterbahnen mit Lastpotential, alternativ auch direkt die Leistungshalbleiterbauelemente.

Erfindungsgemäß weisen die Lastanschlusselemente (40, 42, 44) eine Umhüllung mit einem Isolierstoff auf. Die Lastanschlusselemente sind mit Ausnahme der Bereiche der äußeren und inneren Kontakteinrichtung vorzugsweise vollständig mit diesem Isolierstoff umhüllt und gleichzeitig hierdurch gegeneinander elektrisch isoliert. Es ist zudem besonders bevorzugt, wenn die umhüllten Lastanschlusselemente einen Stapel, der somit eine Fertigungseinheit darstellt, ausbilden.

Die erfinderische Lösung wird an Hand der Ausführungsbeispiele der Fig. 1 bis 3 weiter erläutert.

Fig. 1 zeigt einen Schnitt durch ein Leistungshalbleitermodul gemäß dem Stand der Technik.

Fig. 2 zeigt einen Schnitt durch ein erfindungsgemäßes Leistungshalbleitermodul.

Fig. 3 zeigt in dreidimensionaler Darstellung einen Stapel aus Lastanschlusselementen eines erfindungsgemäßen Leistungshalbleitermoduls.

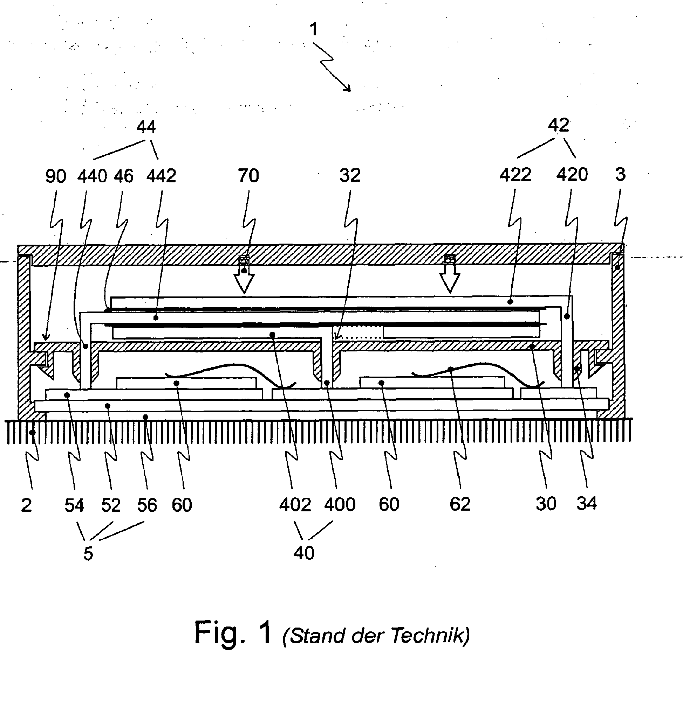

Fig. 1 zeigt einen Schnitt durch ein Leistungshalbleitermodul (1) nach dem Stand der Technik. Dieses Leistungshalbleitermodul (1) weist ein Gehäuse (3) mit einem rahmenartigen Gehäuseteil auf. Der rahmenartige Gehäuseteil umschließt hierbei das mindestens eine Substrat (5). Dieses wiederum weist einen Isolierstoffkörper, (52); vorzugsweise eine Isolierkeramik, wie Aluminiumoxid oder Aluminiumnitrit, auf.

Auf der, dem Inneren des Leistungshalbleitermoduls (1) zugewandten, ersten Hauptfläche weist das Substrat (5) eine in sich strukturierte Metallkaschierung auf. Die einzelnen Abschnitte dieser vorzugsweise als Kupferkaschierung ausgestalteten Metallkaschierung bilden hierbei die Leiterbahnen (54) des Leistungshalbleitermoduls (1) aus. Die zweite Hauptfläche des Substrats (5) weist gemäß dem Stand der Technik eine nicht strukturierte Kupferkaschierung (56) auf.

Auf den Leiterbahnen (54) des Substrats (5) sind steuerbare und / oder ungesteuerte Leistungshalbleiterbauelemente (60) wie beispielhaft IGBTs (insulated gate bipolar Transistor) mit jeweils antiparallel geschalteten Freilaufdioden, oder MOS-FETs angeordnet. Diese sind schaltungsgerecht mit weiteren Leiterbahnen (54), beispielhaft mittels Drahtbondverbindungen (62), verbunden.

Die Lastanschlusselemente (40, 42, 44) für die verschiedenen im Leistungshalbleitermodul auftretenden Potentiale dienen der externen Verbindung der leistungselektronischen Schaltung im Inneren des Leistungshalbleitermoduls (1). Hierzu sind die Lastanschlusselemente (40, 42, 44) als Metallformkörper ausgebildet, die jeweils einen bandartigen Abschnitt (402, 422, 442) parallel zur Substratoberfläche aufweisen. Diese bandartigen Abschnitte (402, 422, 442) bilden hierbei einen Stapel aus, wobei die bandartigen Abschnitte der einzelnen Lastanschlusselemente (40, 42, 44) ausschließlich durch eine notwendige Isolierung (46), beispielhaft in Form einer Kunststofffolie, voneinander beabstandet sind. Derartige Kunststofffolien sind jeweils zwischen benachbarten Anschlusselementen angeordnet um die elektrische Isolierung der unterschiedlichen Potentiale der Anschlusselemente zu gewährleisten. Notwendige Hilfsanschlusselemente sind aus Gründen der Übersichtlichkeit in dieser Schnittzeichnung nicht dargestellt.

Weiterhin weist das Leistungshalbleitermodul (1) eine als Isolierstoffformkörper (30) ausgebildete Zwischenlage zwischen dem Stapel der bandartigen Abschnitte (402; 422, 442) der Lastanschlusselemente (40, 42, 44) und dem Substrat (5) auf. Dieser Isolierstoffformkörper (30) ist in dieser Ausgestaltung in dem rahmenartigen Gehäuse (3) mittels einer Schnapp- Rast- Verbindung (90) angeordnet,

Der Isolierstoffformkörper (30) weist seinerseits Ausnehmungen (32) zur Durchführung von inneren Kontaktierungen, hier von Kontaktfüßen (400, 420, 440), der Lastanschlüsselemente (40, 42, 44) auf. Es ist besonders bevorzugt, wenn diese Ausnehmungen (32) als Führungen für diese Kontaktfüße (400, 42, 44) ausgebildet sind, wodurch die Positionierung der Lastanschlusselemente (40, 42, 44) relativ zum Substrat (5) bzw. dessen Leiterbahnen (54) verbessert ist.

Eine Druckeinrichtung (70) zur thermischen Verbindung des Leistungshalbleitermoduls (1) mit einem Kühlbauteil (2) und gleichzeitig zur elektrischen Kontaktierung der Lastanschlusselemente (40, 42, 44) mit den Leiterbahnen (54) des Substrats (5) wird beispielhaft gebildet durch ein Druckelement zum Druckaufbau sowie ein elastisches Kissenelement zur Druck Speicherung. Der Druck wird über das Kissenelement auf den Stapel aus den bandartigen Abschnitten (402, 422, 442) der Lastanschlusselemente (40, 42, 44) eingeleitet und übt somit Druck auf die Kontaktfüße (400, 420, 440) aus. Hierdurch werden diese elektrisch leitend mit Leiterbahnen (54) des Substrats (5) verbunden.

Derartige Druckkontakierungen (70) haben sich über die Lebensdauer von Leistungshalbleitermodulen (1) als besonders kontaktsicher erwiesen. Weiterhin vorteilhaft für die Druckkontaktierung ist die Ausbildung der Ausnehmungen (32) des Isolierstoffformkörpers (30) als Führungen, da hierdurch die Positionierung der Kontaktfüße (400, 420, 440) besonders genau ist.

Das Druckelement ist beispielhaft als Kunststoffformkörper mit geeigneter, innen liegender Metallseele ausgeführt, wobei hierbei auch auf ein Druck speicherndes Kissenelement verzichtet werden kann. Es ist weiterhin bevorzugt, wenn das Druckelement gleichzeitig den Deckel des Leistungshalbleitermoduls (1) ausbildet.

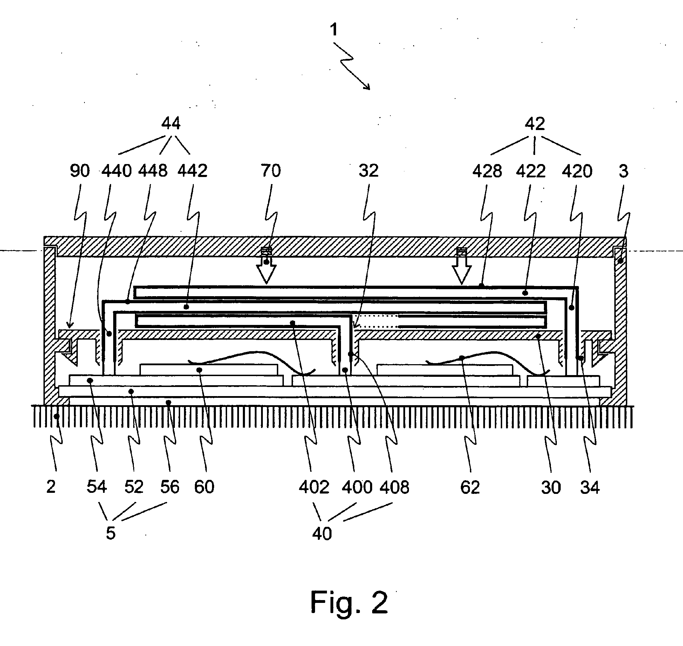

Fig. 2 zeigt einen Schnitt durch ein erfindungsgemäßes Leistungshalbleitermodul (1). In dieser beispielhaften Ausgestaltung ist das Substrat (5), das Gehäuse (3) und die Druckeinrichtung (70) gemäß dem oben genannten Stand der Technik ausgebildet, wobei hierdurch die Erfindung nicht auf diese Ausgestaltung, speziell auf die Ausgestaltung des Leistungshalbleitermoduls in Druckkontaktausführung, beschränkt wird.

Die Ausbildung der Metallformkörper der Lastanschlusselemente (40, 42, 44) entspricht ebenfalls dem Stand der Technik. Gegenüber diesem sind hierbei die Lastanschlusselement (40, 42, 44) erfindungsgemäß derart weiter gebildet, dass sie eine Umhüllung (408, 428, 448) mit einem Isolierstoff aufweisen. Dieser umhüllt das jeweilige Lastanschlusselemente (40, 42, 44) annähernd vollständig. Ausgespart von der Umhüllung sind Teile der Kontakteinrichtungen (400, 420, 440), beispielhaft zu den Leiterbahnen (54) des Substrats (5).

Durch diese erfindungsgemäße Ausbildung der Lastanschlusselemente (40, 42, 44) kann selbstverständlich auf die Anordnung von Kunststofffolien zwischen den Lastanschlusselementen verzichtet werden. Hierdurch wird der.Aufbau des Leistungshalbleitermoduls (1) in einem ersten Schritt vereinfacht. Eine weitere Vereinfachung dieses Aufbaus ergibt sich, wenn die Lastanschlusselemente (40, 42, 44) im Bereich der bandartigen Abschnitte (402, 422, 442) einen Stapel (4) ausbilden. Dies kann beispielhaft durch Verkleben der einzelnen bereits mit Isolierstoff (408, 428, 448) umhüllten Lastanschlusselemente (40, 42, 44) erfolgen. Es kann auch besonders bevorzugt sein, wenn eine Mehrzahl von Lastanschlusselementen (40, 42, 44) in einem Schritt mit Isolierstoff umhüllt werden.

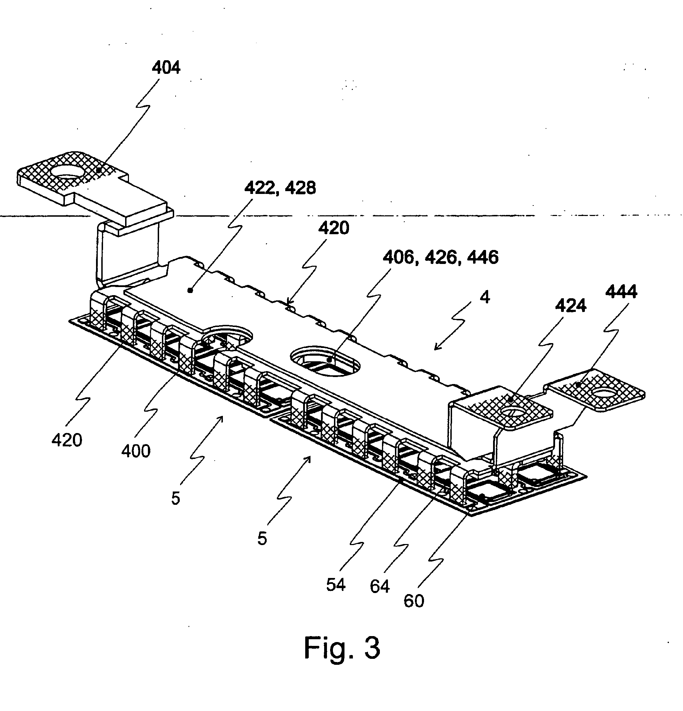

Fig. 3 zeigt in dreidimensionaler Darstellung einen Stapel (4) aus Lastanschlusselementen (40, 42, 44) eines erfindungsgemäßen Leistungshalbleitermoduls. Dargestellt sind Lastanschlusselemente (40, 42, 44), die jeweils eine Mehrzahl von inneren Kontakteinrichtungen, Kontaktfüßen (400, 420, 440), aufweisen, die von zugeordneten bandartigen Abschnitten (402, 422, 442) ausgehen und hier zwei elektrisch parallel geschaltete Substrate (5) schaltungsgerecht kontaktieren. Weitere, äußere, Kontakteinrichtungen (404, 424, 444) der Lastanschlusselemente (40, 42, 44) bilden die externen Anschlüsse des Leistungshalbleitermoduls.

In dieser Ausgestaltung sind die Lastanschlusselemente (40, 42, 44) annähernd vollständig von einem Isolierstoff (408, 428, 448) umhüllt. Von dieser Umhüllung ausgenommen sind Teile der Kontakteinrichtungen (400, 420, 440) zu den Leiterbahnen (54) des Substrats (5) sowie die äußeren Kontakteinrichtungen (404, 424, 444) zur externen elektrischen Verbindung des Leistungshalbleitermoduls.

Es kann bevorzugt sein bei den Kontaktfüßen (400, 420, 440) der Lastanschlusselemente (40, 42, 44) zu den Leiterbahnen (54) des Substrats (5) ausschließlich die Kontaktflächen mit den Leiterbahnen (54) nicht mit Isolierstoff zu bedecken. Es kann ebenso bevorzugt sein, wie hier dargestellt, einen sich von der Substratoberfläche aus erstreckenden Abschnitt, der Kontaktfüße (400, 420, 440) nicht zu umhüllen. In diesem Bereich ist eine Isolierung nicht zwingend notwendig, oder kann beispielhaft durch eine im Inneren des Leistüngshalbleitermoduls angeordnete Vergussmasse vorzugsweise aus einem Silikongel ausgebildet werden.

Die äußeren Kontakteinrichtungen (404, 424, 444) zur externen Kontaktierung sind zumindest an der jeweiligen Kontaktfläche für die elektrisch leitende Verbindung nicht umhüllt. Auch hier kann die Umhüllung ausgehend von den jeweiligen Kontaktflächen in Richtung des jeweiligen bandartigen Abschnitts (402, 422, 442) ausgespart sein. Die exakte Ausbildung der Umhüllung (408, 428, 448) ist abhängig von den jeweiligen Anforderungen an die Isolierung der Lastanschlusselemente (40, 42, 44) zueinander sowie von der geometrischen Ausbildung des Leistungshalbleitermoduls, beispielhaft von dessen Gehäuseform.

Es ist besonders vorteilhaft, wenn die jeweilige Umhüllung (408, 428, 448) der einzelnen Lastanschlusselemente (40, 42, 44) mittels eines Spritz-, oder eines Tauchverfahrens ausgebildet ist. Als Anforderung für den Isolierstoff selbst, beispielhaft ein Thermoplast auf Polyamidbasis, hat sich eine Kriechstromfestigkeit mit einem CTI-Wert von größer 400, besser noch von größer 600, als besonders geeignet erwiesen.

Es ist ebenso besonders vorteilhaft, wenn die Lastanschlusselemente (40, 42, 44) bevorzugt im Bereich der bandartigen Abschnitte (402, 422, 442) zu einer Montageeinheit verbunden sind. Diese kann beispielhaft durch eine Klebeverbindung der einzelnen mit Isolierstoff (408, 428, 448) umhüllten Lastanschlusselemente (40, 42, 44) ausgebildet sein. Es kann allerdings auch bevorzugt sein eine Mehrzahl, vorteilhafterweise alle, Lastanschlusselemente (40, 42, 44) in einem gemeinsamen Verfahrensschritt mit dem Isolierstoff (408, 428, 448) zu umhüllen. Somit wird eine besonders vorteilhaft zu verarbeitende Montageeinheit ausgebildet.

Die jeweiligen Lastanschlusselemente (40, 42, 44) oder ein daraus gebildeter Stapel (4) von Lastanschlusselementen (40, 42, 44) weisen weiterhin Ausnehmungen (406, 426, 446) bevorzugt im Bereich der bandartigen Abschnitte (402, 422, 442) auf. Diese Ausnehmungen (406, 426, 446) sind ausgebildet zur Durchführung von vorteilhafterweise als Schraubenfedern ausgebildeten, nicht dargestellten, Hilfsanschlusselementen. Hierbei sind selbstverständlich die Ränder der gebildeten Ausnehmungen (406, 426, 446) ebenfalls mit dem Isolierstoff (408, 428, 448) umhüllt.

## Patentansprüche

1. Leistungshalbleitermodul (1), zur Anordnung auf einem Kühlbauteil (2), mit mindestens einem Substrat (5), mindestens zwei hierauf angeordneten Leistungshalbleiterbauelementen (60), einem Gehäuse (3) und nach außen führenden Last- (40, 42, 44) und Steueranschlusselementen, wobei das Substrat (5) einen Isolierstoffkörper (52) aufweist und auf dessen erster dem Inneren des Leistungshalbleitermoduls zugewandten Hauptfläche Leiterbahnen (54) mit Lastpotential angeordnet sind
wobei die Lastanschlusselemente jeweils als Metallformkörper mit äußeren Kontakteinrichtungen (404, 424, 444) einem bandartigen Abschnitt (402, 422, 442) und mit von diesem ausgehenden inneren Kontakteinrichtungen (400, 420, 440) ausgebildet sind, die inneren Kontakteinrichtungen von dem bandartigen Abschnitt zum Substrat (5) reichen und dieses schaltungsgerecht kontaktieren, und
wobei die Lastanschlusselemente (40, 42, 44) im Bereich der bandartigen Abschnitte (402, 422, 442) einen Stapel (4) bilden, und
wobei die Lastanschlusselemente (40, 42, 44) mit Ausnahme der Bereich der äußeren und inneren Kontakteinrichtung vollständig von einem Isolierstoff (408, 428, 448) umhüllt und hierdurch gegeneinander elektrisch isoliert sind.

2. Leistungshalbleitermodul (1) nach Anspruch 1,
in Druckkontaktausführung mit einer Druckeinrichtung (70).

3. Leistungshalbleitermodul (1) nach Anspruch 1
wobei der Isolierstoff (408, 428, 448) einen CTI- Wert von mehr als 400 aufweist.

4. Leistungshalbleitermodul (1) nach Anspruch 1,
wobei der Isolierstoff (408, 428, 448) mittels eines Tauchverfahrens angeordnet ist.

5. Leistungshalbleitermodul (1) nach Anspruch 1,
wobei der Isolierstoff (408, 428, 448) mittels eines Spritzverfahrens angeordnet ist.

6. Leistungshalbleitermodul (1) nach Anspruch 1
wobei der Stapel (4) durch Verkleben ausgebildet ist.

7. Leistungshalbleitermodul (1) nach Anspruch 1
wobei der Stapel (4) durch gleichzeitiges Anordnen des Isolierstoffs (408, 428, 448) an einer Mehrzahl von Lastanschlusselementen (40, 42, 44) ausgebildet ist.

8. Leistungshalbleitermodul (1) nach einem der vorgenannten Ansprüche,
wobei die Druckeinrichtung (70) und / oder der Stapel (4) Ausnehmungen (406, 426, 446, 466) zur Durchführung von als Schraubenfedern ausgebildeten Hilfsanschlusselementen aufweisen.

## Claims

1. A power semiconductor module (1) for purposes of arrangement on a cooling component (2) with at least one substrate (5), at least two power semiconductor components (60) arranged on the substrate, a housing (3) and load (40, 42, 44) and control terminal elements routed outwards, wherein
the substrate (5) has a body of insulation material (52) and on its first prime surface facing towards the interior of the power semiconductor module are arranged conducting tracks (54) at load potential, wherein
the load terminal elements in each case are designed as shaped metal bodies with external contact devices (404, 424, 444), a strip-type section (402, 422, 442) and with internal contact devices (400, 420, 440) emanating from the latter, the internal contact devices extending from the strip-type section to the substrate (5) and making contact with the latter in a manner appropriate to the circuit, and wherein
the load terminal elements (40, 42, 44) form a stack (4) in the region of the strip-type sections (402, 422, 442), and wherein
the load terminal elements (40, 42, 44), with the exception of the regions of the external and internal contact devices, are preferably completely encased in an insulation material (408, 428, 448) and are hereby electrically insulated from one another.

2. The power semiconductor module (1) according to Claim 1,
in a pressure contact embodiment with a pressure device (70).

3. The power semiconductor module (1) according to Claim 1, wherein
the insulation material (408, 428, 448) has a CTI value of more than 400.

4. The power semiconductor module (1) according to Claim 1, wherein
the insulation material (408, 428, 448) is arranged by means of an immersion method.

5. The power semiconductor module (1) according to Claim 1, wherein
the insulation material (408, 428, 448) is arranged by means of an injection method.

6. The power semiconductor module (1) according to Claim 1, wherein
the stack (4) is formed by a process of adhesion.

7. The power semiconductor module (1) according to Claim 1, wherein
the stack is formed by the simultaneous arrangement of the insulating material (408, 428, 448) on a number of load terminal elements (40, 42, 44).

8. The power semiconductor module (1) according to one of the previous claims, wherein
the pressure device (70) and/or the stack (4) have openings (406, 426, 446, 466) for the through-routeing of ancillary terminal elements designed as coil springs.

## Revendications

1. Module à semi-conducteur de puissance (1), pour un placement sur un composant réfrigérant (2), comprenant au moins un substrat (5) au moins deux composants à semi-conducteur de puissance (60) disposés dessus, un boîtier (3) et des éléments de raccordement de charge (40, 42, 44) et de raccordement de commande allant vers l'extérieur, le substrat (5) présentant un corps en matière isolante (52) et des pistes conductrices (54) avec potentiel de charge étant disposées sur la première surface principale, tournée vers l'intérieur du module à semi-conducteur de puissance, du substrat,
les éléments de raccordement de charge étant réalisés à chaque fois sous forme de corps moulé en métal avec des dispositifs de contact (404, 424, 444) extérieurs, une partie (402, 422, 442) de type bande et avec des dispositifs de contact (400, 420, 440) intérieurs partant de cette partie, lesquels dispositifs de contact intérieurs vont de la partie en forme de bande vers le substrat (5) et établissent un contact avec le substrat de façon adaptée au montage, et
les éléments de raccordement de charge (40, 42, 44) formant une pile (4) dans la zone des parties en forme de bande (402, 422, 442), et
les éléments de raccordement de charge (40, 42, 44), à l'exception des zones du dispositif de contact extérieur et du dispositif de contact intérieur, étant complètement enveloppés par un produit isolant (408, 428, 448) et étant ainsi isolés électriquement les uns par rapport aux autres.

2. Module à semi-conducteur de puissance (1) selon la revendication 1, dans une version de contact de pression avec un système de pression (70).

3. Module à semi-conducteur de puissance (1) selon la revendication 1, le matériau isolant (408, 428, 448) présentant une valeur CTI de plus de 400.

4. Module à semi-conducteur de puissance (1) selon la revendication 1, le matériau isolant (408, 428, 448) étant disposé au moyen d'un procédé d'immersion.

5. Module à semi-conducteur de puissance (1) selon la revendication 1, le matériau isolant (408, 428, 448) étant disposé au moyen d'un procédé d'injection.

6. Module à semi-conducteur de puissance (1) selon la revendication 1, la pile (4) étant réalisée par collage.

7. Module à semi-conducteur de puissance (1) selon la revendication 1, la pile (4) étant réalisée par placement simultané du matériau isolant (408, 428, 448) sur une pluralité d'éléments de raccordement de charge (40, 42, 44).

8. Module à semi-conducteur de puissance (1) selon l'une quelconque des revendications précédentes, le système de pression (70) et/ou la pile (4) présentant des évidements (406, 426, 446, 466) pour le passage d'éléments de raccordement auxiliaire conçus sous forme de ressorts hélicoïdaux.
